# EUROPÄISCHE PATENTSCHRIFT

(11) **EP 2 398 057 B1**
(45) Veröffentlichungstag und Bekanntmachung des Hinweises auf die Patenterteilung: **24.07.2019**
(21) Anmeldenummer: 11166656.6
(22) Anmeldetag: 19.05.2011
(51) Int. Cl.: H01L 29/06, H01L 29/36, H01L 29/861, H01L 29/40

(54) **Leistungshalbleiterbauelement mit zweistufigem Dotierungsprofil**
High performance semi-conductor element with two stage doping profile
Composant semi-conducteur de puissance doté d'un profil de dopage à deux niveaux

(30) Priorität: 18.06.2010 DE 102010024257
(43) Veröffentlichungstag der Anmeldung: 21.12.2011
(73) Patentinhaber: SEMIKRON Elektronik GmbH, 90431 Nürnberg (DE)
(72) Erfinder: Dr. König, Bernhard, 90765, Fürth (DE)

(56) Entgegenhaltungen:
- EP-A1- 0 364 760
- EP-A2- 1 394 860
- DE-B3-102006 025 958
- US-A1- 2007 228 490
- US-A1- 2009 072 340
- US-A1- 2010 019 342
- US-B1- 6 177 713

## Beschreibung

Die Erfindung beschreibt ein Leistungshalbleiterbauelement mit mindestens einem funktionalen pn- Übergang, beispielhaft eine Leistungsdiode, bestehend aus einem Grundkörper aus einem Halbleitermaterial erster Leitfähigkeit, vorzugsweise aus monokristallinem Silizium.

Aus dem Stand der Technik beispielhaft gemäß der DE 43 37 329 A1 ist es zur Herstellung von Leistungsdioden bekannt, diese mit Heliumatomkernen und / oder Elektronen zu bestrahlen, sowie ggf. eine zusätzliche Platindiffusion vorzusehen um insbesonder das Schaltverhalten, speziell für den Anwendungszweck als Freilaufdiode, zu verbessern.

Aus der EP 1 017 093 A1 ist ein Leistungshalbleiterbauelement mit zwei funktionalen pn- Übergängen bekannt dessen Rückseite ein zweistufige Dotierungsprofil aufweist. Dieses Profil wird erzeugt durch eine erste Tiefe Diffusion mit einem Dotierstoff der Leitfähigkeit des Grundkörpers, ein anschließendes weitgehendes Abschleifen diese dotierten Bereichs und eine zweite sehr flache Diffusion eines Dotierstoffes zweiter Leitfähigkeit und hoher Dotierstoffkonzentration.

Aus der US 2010/0019342 A1 ist eine Halbleitervorrichtung, die eine PN-Übergangdiodenstruktur aufweist, bekannt.

Aus der US 6177713 B1 ist eine Halbleitervorrichtung mit einem Halbleitersubstrat eines ersten Leitungstyps, und mit einem ersten Dotierstoffdiffusionsbereich eines zweiten Leitungstyps bekannt.

Aus der EP 0 364 760 A1 (ASEA BROWN BOVERI [DE]) 25. April 1990 (1990-04-25) ist eine Halbleitervorrichtung, die eine PN-Übergangdiodenstruktur aufweist, bekannt.

Der Erfindung liegt die Aufgabe zugrunde ein Leistungshalbleiterbauelement vorzustellen, das einem einfachen Herstellungsprozess, auch ohne Bestrahlung mit Teilchen, zugänglich ist und gleichzeitig geringe Sperrströme wie auch gering Durchlass- und Schaltverluste aufweist.

Die Aufgabe wird erfindungsgemäß gelöst, durch ein Leistungshalbleiterbauelement mit den Merkmalen des Anspruchs 1. Bevorzugte Ausführungsformen sind in den jeweiligen abhängigen Ansprüchen beschrieben.

Das erfindungsgemäße Leistungshalbleiterbauelement weist mindestens einen funktionalen pn- Übergang zur Ausbildung einer Funktion als ein Stromventil, bevorzugt als eine Diode, auf. Hierzu weist das Leistungshalbleiterbauelement einen Grundkörper erster Basisleitfähigkeit auf, das meist als n⁻ Dotierung ausgebildet ist, häufig einer n-Dotierung mit geringer Dotierkonzentration von typisch zwischen 10¹³ und 10¹⁴ cm⁻³. In diesen Grundkörper eingebettet und horizontal mittig an einer ersten Seite angrenzend an eine erste Hauptfläche angeordnet weist das Leistungshalbleiterbauelement ein wannenförmiges Gebiet zweiter Leitfähigkeit auf, wobei dieses mit einem ersten zweistufigen Dotierungsprofil und mit einer erster Eindringtiefe von der ersten Hauptfläche in den Grundkörper hinein ausgebildet ist. Die Stufe des zweistufigen Dotierprofils des wannenförmigen Gebiets ist im Bereich zwischen 10% und 40% der ersten Eindringtiefe angeordnet. Es ist aus Gründen der elektrischen Kontaktierung mit einer Metallkontaktschicht ebenso vorteilhaft, wenn die Konzentration an zweiten Dotierstoffatomen an der ersten Hauptfläche des wannenförmigen Gebiets zwischen 10¹⁷ und 10²⁰ cm⁻² beträgt. Unter Eindringtiefe eines Dotierprofils soll hier und im Folgenden diejenige Entfernung von derjenigen Oberfläche, von der die Dotierung aus erfolgt, verstanden werden in der die Dotierstoffkonzentration den Absolutwert der Grunddotierung erreicht.

Zwischen diesem wannenförmigen Gebiet und dem Rand des Leistungshalbleiterbauelements ist ebenfalls an der ersten Hauptfläche eine Randstruktur aus einer Mehrzahl von Feldringen mit einstufigem Dotierungsprofil, zweiter Leitfähigkeit und zweiter Eindringtiefe angeordnet. Diese Randstruktur zugeordnet ist eine den Feldringen zugeordneten Feldplattenstruktur sowie eine Passivierung. Erfindungsgemäß beträgt die erste Eindringtiefe maximal 50% der zweiten Eindringtiefe.

Die Feldplattenstruktur ist ausgebildet aus, jedem Feldring zugeordneten, leitfähigen Formkörpern mit je einem ersten Teilkörper horizontal mittige auf dem Feldring angeordnet. Horizontal ist zwischen diesen ersten Teilkörpern eine erste Passivierungsschicht vorgesehen. Weiterhin ist mindestens ein jeweiliger zweiter Teilkörper des leitfähigen Formkörpers vorgesehen, der von dem Grundkörper mittels der ersten Passivierungsschicht beabstandet angeordnete ist. Hierbei überragt dieser ein jeweiliger zweiter Teilkörper den zugeordneten Feldring horizontal in Richtung des Randes des Leistungshalbleiterbauelements. Zusätzlich kann es bevorzugt sein, wenn mindestens eine, oder ein weiterer, zweite Teilkörper mindestens einen zugeordneten Feldring horizontal in Richtung der Mitte des Leistungshalbleiterbauelements überragt.

Vorteilhafterweise ist oberhalb der ersten Passivierungsschicht eine zweite Passivierungsschicht angeordnet, die die leitfähigen Formkörper bzw. die erste Passivierungsschicht vollständig überdeckt. Es kann hierbei weiterhin bevorzugt sein zwischen der ersten und der zweiten Passivierungsschicht eine Schicht aus Siliziumnitrit anzuordnen.

Die vorteilhafte Ausgestaltung der zugehörigen zweiten Seite angrenzend an die zweite Hauptfläche des Leistungshalbleiterbauelements weist folgende Merkmale auf. Von der zweiten Hauptfläche erstreckt sich ins Innere des Grundkörpers hinein ein zweites zweistufiges Dotierungsprofil, mit zwei Teilprofilen, erster Leitfähigkeit mit einer dritten Eindringtiefe. Hierbei beträgt diese dritte Eindringtiefe, diejenige des ersten Teilprofils dieses zweiten Dotierungsprofils, abhängig von der Spannungsklasse und damit von der notwendigen Dicke des Leistungshalbleiterbauelements in etwa die halbe laterale Ausdehnung des Grundkörpers. Weiterhin ist es vorteilhaft, wenn das zweite Teilprofil eine vierte Eindringtiefe aufweist und diese vierte Eindringtiefe zwischen 40% und 70%, vorzugsweise zwischen 50% und 60%, der dritten Eindringtiefe des ersten Teilprofils beträgt. Die gesamte Eindringtiefe des zweiten Dotierungsprofils ist somit identisch der Eindringtiefe von dessen erstem Teilprofil. Weiterhin soll die vierte Eindringtiefe des zweiten Teilprofils des zweiten zweistufigen Dotierungsprofils mindestens 20%, vorzugsweise mindestens 30%, der lateralen Ausdehnung des Grundkörpers betragen.

Ebenso bevorzugt ist es, wenn die Konzentration von Dotierstoffatomen an der zweiten Hauptfläche mit erster Leitfähigkeit, erzeugt durch das erste Teilprofil, um mindesten 2 Größenordnungen geringer ist als dasjenige erzeugt durch das zweite Teilprofil, und wobei die Konzentration von Dotierstoffatomen an der zweiten Hauptfläche zwischen 10¹⁸ und 10²¹ cm⁻² beträgt. Üblicherweise ist an dieser zweiten Hauptfläche eine weitere Kontaktmetallisierung, vergleichbar derjenigen des wannenförmigen Gebiets angeordnet. Hierbei ist die spezielle Ausgestaltung dieser Metallisierungen an die jeweils zu verwendende externe Verbindungstechnologie angepasst.

Die erfinderische Lösung wird an Hand der Ausführungsbeispiele und der Fig. 1 bis 6 weiter erläutert.
Fig. 1 zeigt einen Ausschnitt eines erfindungsgemäßen Leistungshalbleiterbauelements im Querschnitt.
Fig. 2 zeigt die Dotierkonzentration an der ersten Hauptfläche eines erfindungsgemäßen Leistungshalbleiterbauelements.
Fig. 3 zeigt zwei weitere Ausführungsformen eines erfindungsgemäßen Leistungshalbleiterbauelements im Ausschnitt.
Fig. 4 und 5 zeigen Dotierkonzentration von Leistungshalbleiterbauelementen gemäß dem Stand der Technik.
Fig. 6 zeigt die gesamte Dotierkonzentration eines erfindungsgemäßen Leistungshalbleiterbauelements.

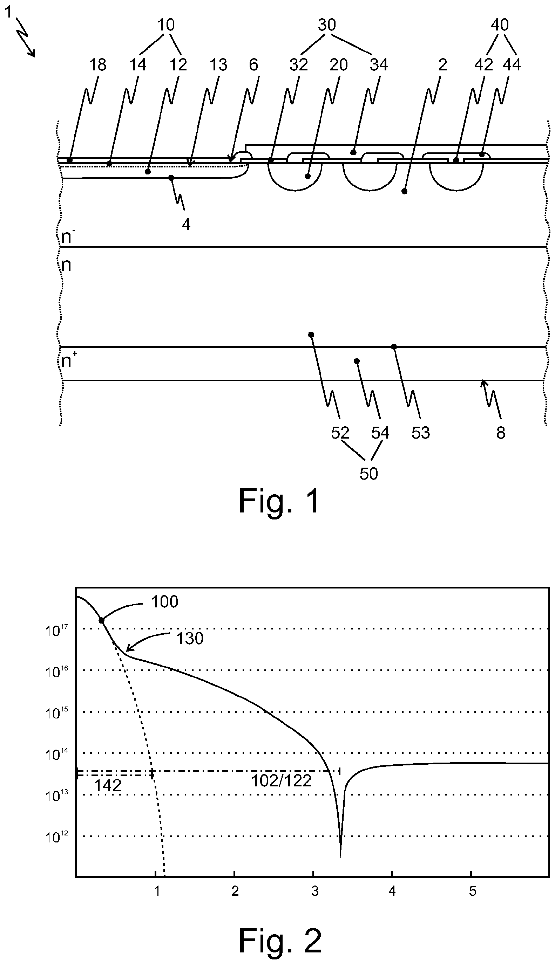

Fig. 1 zeigt einen Ausschnitt eines erfindungsgemäßen Leistungshalbleiterbauelements (1) im Querschnitt, während Fig. 2 die zugeordnete Dotierkonzentration an der ersten Hauptfläche eines erfindungsgemäßen Leistungshalbleiterbauelements (1), hier einer Leistungsdiode der Spannungsklasse 1200V, über der Dicke des Leistungshalbleiterbauelements (1) zeigt.

Dargestellt in Fig. 1 ist ein Ausschnitt des Grundkörpers (2), wie er beispielhaft aus einer Vielzahl von Leistungshalbleiterdioden bekannt ist, mit einer ersten Basisleitfähigkeit, typisch einer schwachen n- Dotierung. An der ersten Hauptfläche (6) und von diese sich lateral ins Innere des Grundkörpers (2) hinein erstreckend ist ein wannenförmiges Gebiet (10) zweiter, hier p- Leitfähigkeit, zur Ausbildung eines pn- Übergangs (4) dargestellt.

Erfindungsgemäß ist dieses wannenförmige Gebiet (10) ausgebildet mittels eines zweistufigen Dotierungsprofils (100), wodurch die gesamte Eindringtiefe (102) gering, hier im Bereich zwischen 3µm und 4µm, ist. Gleichzeitig ist die Dotierstoffkonzentration an der Oberfläche des wannenförmigen Gebiets (10) ausreichend hoch, hier im Bereich zwischen 10¹⁷ und 10¹⁸ cm⁻², um den elektrischen Widerstand beim Übergang zu einer hierauf angeordneten Metallkontaktschicht (18) ausreichend gering auszubilden. Die Stufe (130) dieses ersten Dotierprofils (100) ist im Bereich von 10% bis 40% der Eindringtiefe (102) des Gesamtprofils ausgebildet. Gebildet wird dieses Dotierungsprofil durch zwei Teilprofile mit einer ersten Eindringtiefe (122) von 3µm bis 4µm, die schließlich identisch der gesamten Eindringtiefe (102) ist und einem zweiten Teilprofil mit einer zweiten Eindringtiefe (142) geeignet zur Ausbildung des genannten ersten Dotierprofils (100).

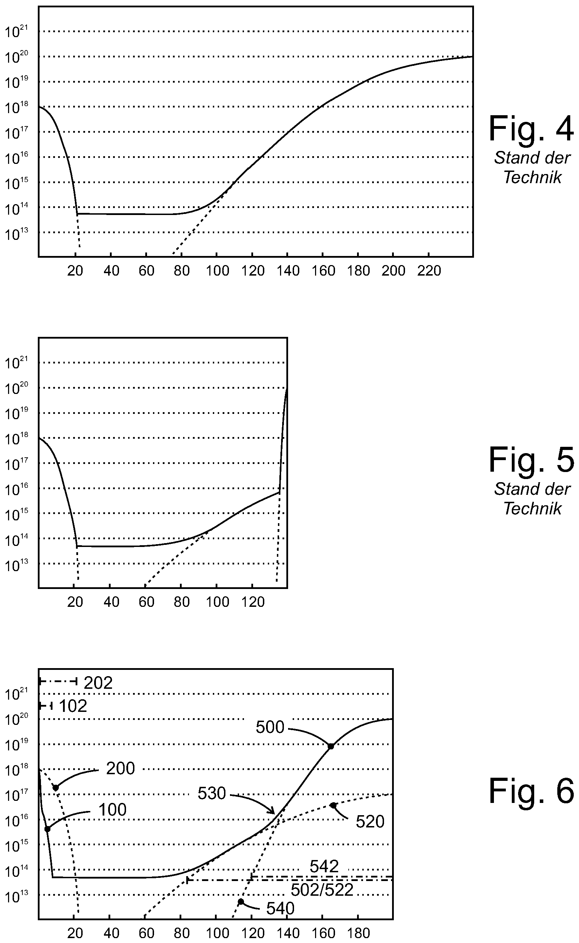

Diese derart ausgebildete wannenförmige Gebiet (10) ist horizontal mittig im Grundkörper (2) des Leistungshalbleiterbauelements (1) angeordnet und wird allseits von einem Randgebiet umgeben. Dieses Randgebiet weist im Grundkörper (2) eine Mehrzahl von Feldringen (20) auf, ihrerseits ausgebildet mit einem zweiten einstufigen Dotierungsprofil (200, vgl. Fig. 6) zweiter, hier p-, Leitfähigkeit. Wesentlich hierbei ist, dass die Eindringtiefe (202) dieses zweiten Dotierungsprofils (200) der Feldringe (20) größer ist als diejenige Eindringtiefe (102) des ersten Dotierungsprofils (100) des wannenförmigen Gebiets (10). Es ist bevorzugt wenn diese erste Eindringtiefe (102) idealerweise bis zu 30%, aber maximal bis zu 50%, der zweiten Eindringtiefe (202) beträgt.

Das Randgebiet weist weiterhin eine Feldplattenstruktur auf, wobei einzelne leitfähige Formkörper (40) diese Feldplattenstruktur ausbilden. Die jeweiligen leitfähigen Formkörper (40) sind einstückig aus Teilkörpern (42, 44) ausgebildet, wobei der jeweilige erste Teilkörper (42) in horizontaler Richtung mittig auf dem zugeordneten Feldringen und in elektrischem Kontakt mit diesen angeordnet ist. Der gesamte leitfähige Formkörper (40) besteht hierbei aus Metall oder geeignet dotiertem Polysilizium.

Zwischen der Metallkontaktschicht (18) des wannenförmigen Gebiets (10) und dem ersten horizontal benachbarten Teilkörper (42), sowie zwischen allen weiteren ersten Teilkörpern (42) ist eine erste Passivierungsschicht (32) angeordnet, die vorteilhafterweise aus Siliziumoxid gebildet durch ein Oxidation des Grundkörpers (2) in diesem Bereich, besteht.

Der zweite Teilkörper (44) des jeweiligen leitfähigen Formkörpers (40) ist von dem Grundkörper (2) beabstandet angeordnet und überlappt horizontal zumindest in Richtung des Randes, vorteilhafterweise allerdings auch, zumindest bei einem leitfähigen Formkörper (40), den ersten Teilkörper (42) derart, dass diese Überlappung über die horizontale Ausdehnung des zugeordneten Feldrings (20) hinaus geht.

Weiterhin dargestellt ist eine zweite Passivierungsschicht (34), vorzugsweise aus einem Polyimid ausgebildet, die die freien Bereiche der ersten Passivierungsschicht (32) sowie die Feldplattenstruktur (40) vollständig überdeckt. Es kann weiterhin bevorzugt sein zwischen den beiden Passivierungsschichten (32, 34) eine Zwischenschicht aus Siliziumnitrit anzuordnen.

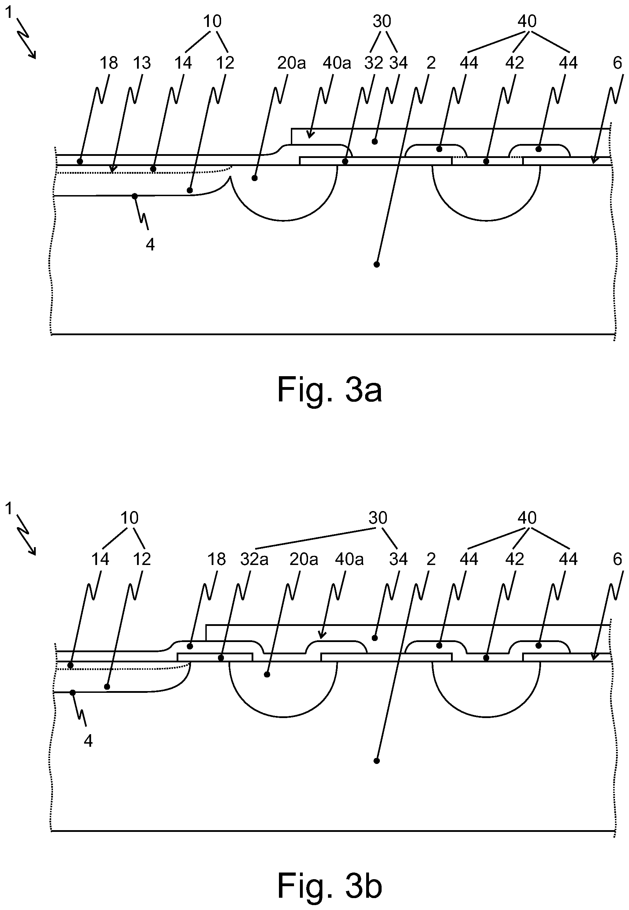

Fig. 3 zeigt zwei weitere Ausführungsformen eines erfindungsgemäßen Leistungshalbleiterbauelements (1) im Ausschnitt. Die Ausführungsform gemäß Fig. 3a unterscheidet sich von derjenigen gemäß Fig. 1 dadurch, dass der erste Feldring (20a) mit dem wannenförmigen Gebiet (10) überlappt, also zwischen diesem und dem ersten Feldring kein Abstand vorliegt. Zudem ist hierbei die Metallkontaktschicht (18) des wannenförmigen Gebiets (10) einstückig mit dem leitfähigen Formkörper (40a) des ersten Feldrings (20a) ausgebildet.

Bei der Ausgestaltung gemäß Fig. 3b ist ebenfalls die Metallkontaktschicht (18) des wannenförmigen Gebiets (10) einstückig mit dem leitfähigen Formkörper (40a) des ersten Feldrings (20a) ausgebildet, wobei hier dieser Feldring (20a) von dem wannenförmigen Gebiet (10) analog der Ausgestaltung gemäß Fig. 1 beabstandet ist. Hierbei ist ebenso wie bei der Ausgestaltung gemäß Fig. 1 im Bereich oberhalb des Grundkörpers (2) horizontal zwischen dem wannenförmigen Gebiet (10) und dem ersten Teilkörper des ersten leitfähigen Formkörpers (40a) des ersten Feldrings (20a) eine erste Passivierungsschicht (32) angeordnet ist.

Fig. 4 und 5 zeigen Dotierkonzentration aufgetragen über die Dicke von der ersten Hauptfläche von Leistungshalbleiterbauelementen gemäß dem Stand der Technik. Fig. 4 zeigt das typische Profil eine Leistungsdiode der Spannungsklasse 1200V, wobei hier auf der zweiten Seite ein einstufiges tiefes Dotierungsprofil ausgebildet ist. Bei einstufigen Profilen ist diese tiefe Dotierung notwendig um im Inneren der Leistungsdiode am Beginn des Dotierungsprofils ein möglichst geringe Steigung auszubilden und gleichzeitig an der Oberfläche eine hohe Dotierstoffkonzentration zu erreichen um den elektrischen Widerstand zu eine Metallkontaktschicht möglichst gering zu halten. Ein derartiges Profil bedingt somit auch eine relativ große laterale Ausdehnung, hier von über 240µm, des Grundkörpers.

Fig. 5 zeigt eine im Gegensatz hierzu in Dünnwafertechnologie hergestellte Leistungsdiode der Spannungsklasse 1200V mit einer Dicke von nur 140µm und mit zweistufigem Dotierungsprofil gemäß dem Stand der Technik, wobei die Stufe diese Dotierungsprofils fast unmittelbar an der zweiten Oberfläche ausgebildet ist.

Fig. 6 zeigt die gesamte Dotierkonzentration sowie den Dotierungsverlauf eines erfindungsgemäßen Leistungshalbleiterbauelements (1), hier ebenfalls einer Leistungsdiode der Spannungsklasse 1200V, aufgetragen über seine Dicke von der ersten Hauptfläche (6, vgl. Fig. 1) an. An der ersten Hauptfläche ist eine erste Dotierstoffkonzentration wie bereits in Fig. 2 dargestellt gezeigt. Zusätzlich ist hier das zweite Dotierungsprofil (200) mit zweiter Eindringtiefe (202) eines Feldrings dargestellt.

Die zweite Seite ausgehend von der zweiten Hauptfläche (8, vgl. Fig. 1) weist grundsätzlich wie bei einer Leistungsdiode gemäß Fig. 5 ein zweistufiges Dotierungsprofil auf. Im Unterschied zum Stand der Technik ist hierbei allerdings die laterale Ausdehnung des Wafers größer gewählt um die Handlingsnachteile der Dünnwafertechnologie, wie auch den hierbei notwendigen Abschleifprozess, zu umgehen. Weiterhin wird für diese Leistungsdiode die Eindringtiefe derjenigen Dotierung mit höherer Konzentration an Dotierstoffatomen wie auch das Verhältnis der beiden das Dotierungsprofil bildenden Einzelprofile unterschiedlich zum Stand der Technik gemäß Fig. 5 gewählt.

Das tiefere, flache, erst Teilprofil (520) mit der dritten Eindringtiefe (522) und somit das gesamte zweiten Dotierungsprofils reicht mit seiner Eindringtiefe (502) bei dieser Diode der Spannungsklasse 1200V lateral in etwa bis zur Mitte des Grundkörpers der Leistungsdiode (1). Das zweite und steilere Teilprofil (540) weist eine vierte Eindringtiefe (542) auf, die zwischen 40% und 70%, vorzugsweise zwischen 50% und 60%, der dritten Eindringtiefe (522) beträgt. Weiterhin weist dieses zweite Teilprofil (540) eine Eindringtiefe (542) auf, die mindestens 20% der lateralen Ausdehnung, hier von 200µm, des Grundkörpers beträgt.

Durch diese Ausbildung des zweiten zweistufigen Dotierungsprofils (500) ist es möglich gleichzeitig eine geringe Steigung am Beginn des Profils auszubilden wie auch eine Konzentration von Dotierstoffatomen an der zweiten Hauptfläche zwischen 10¹⁸ und 10²¹ cm⁻² zu erzielen. Anderseits liegt bei dieser Ausgestaltung des zweiten zweistufigen Dotierungsprofils (500) die laterale Ausdehnung des Grundkörpers über derjenigen gemäß Fig. 5, wodurch die Handlingsnachteile der Dünnwafertechnologie nicht auftreten.

## Patentansprüche

1. Leistungshalbleiterbauelement (1) mit mindestens einem funktionalen pn- Übergang (4), mit einem Grundkörper (2) erster Basisleitfähigkeit,
einem horizontal mittig in dem Grundkörper (2) angeordneten wannenförmigen Gebiet (10) zweiter Leitfähigkeit mit einem ersten zweistufigen Dotierungsprofil (100) und mit einer erster Eindringtiefe (102) von der ersten Hauptfläche (6) in den Grundkörper (2) hinein, wobei die Stufe (130) des ersten zweistufigen Dotierprofils (100) des wannenförmigen Gebiets (10) im Bereich zwischen 10% und 40% der ersten Eindringtiefe (102) ausgebildet ist, wobei das erste zweistufige Dotierprofil (100) gebildet wird durch zwei Teilprofile mit der ersten Eindringtiefe (122) von 3µm bis 4µm und einem zweiten Teilprofil mit einer zweiten Eindringtiefe (142) geeignet zur Ausbildung des genannten ersten zweistufigen Dotierprofils (100),
mit einer zwischen dem wannenförmigen Gebiet (10) und dem Rand des Leistungshalbleiterbauelements (1) angeordnete Randstruktur aus einer Mehrzahl von Feldringen (20) mit einstufigem Dotierungsprofil, zweiter Leitfähigkeit und zweiter Eindringtiefe (202), angeordnet in dem Grundkörper (2), einer diesen Feldringen (20) zugeordneten Feldplattenstruktur (40) und einer Passivierung (30) dieser Randstruktur, wobei
die erste Eindringtiefe (102) maximal 50 von 100 der zweiten Eindringtiefe (202) beträgt,
jedem Feldring (20) ein leitfähiger Formkörper (40) als Feldplatte mit einem ersten Teilkörper (42) horizontal mittige auf dem Feldring (40) angeordnet, zugeordnet ist, wobei zwischen diesen ersten Teilkörpern (42) eine erste Passivierungsschicht (32) angeordnet ist und mit mindestens einem zweiten Teilkörper (44), der von dem Grundkörper (2) lateral beabstandet ist und horizontal den zugeordneten Feldring (20) in Richtung des Randes des Leistungshalbleiterbauelements (1) überragt.

2. Leistungshalbleiterbauelement nach Anspruch 1, wobei
ein zweiter Teilkörper (44) den zugeordneten Feldring (20) horizontal in Richtung der Mitte des Leistungshalbleiterbauelements (1) überragt.

3. Leistungshalbleiterbauelement nach Anspruch 1, wobei
die Konzentration an zweiten Dotierstoffatomen an der ersten Hauptfläche (6) des wannenförmigen Gebiets (10) zwischen 10¹⁷ und 10²⁰ cm⁻² beträgt.

4. Leistungshalbleiterbauelement nach Anspruch 1, wobei
auf der Oberfläche des wannenförmigen Gebiets (10) zweiter Leitfähigkeit eine Metallkontaktschicht (18) angeordnet ist.

5. Leistungshalbleiterbauelement nach Anspruch 1, wobei
oberhalb der ersten Passivierungsschicht (32) eine zweite Passivierungsschicht (34) angeordnet ist.

6. Leistungshalbleiterbauelement nach Anspruch 5, wobei
die erste Passivierungsschicht (32) Siliziumoxid und die zweite Passivierungsschicht (34) ein Polyimid ist.

7. Leistungshalbleiterbauelement nach Anspruch 6, wobei
zwischen der ersten (32) und der zweiten Passivierungsschicht (34) eine Schicht aus Siliziumnitrit angeordnet ist.

8. Leistungshalbleiterbauelement nach Anspruch 5, wobei
die zweite Passivierungsschicht (34) die leitfähigen Formkörper (40) vollständig überdeckt.

9. Leistungshalbleiterbauelement nach Anspruch 1, wobei
der leitfähige Formkörper (40) und seine Teilkörper (42, 44) aus Metall oder aus dotiertem Polysilizium bestehen.

10. Leistungshalbleiterbauelement nach Anspruch 1, wobei
von der zweiten Hauptfläche (8) ein sich ins Innere des Grundkörpers (2) ausdehnendes zweites zweistufiges Dotierungsprofil (500) erster Leitfähigkeit mit einer dritten Eindringtiefe (502) ausgebildet ist, wobei diese dritte Eindringtiefe (502) der ersten Dotierung des zweiten Dotierungsprofils (500) im Bereich der halben laterale Ausdehnung des Grundkörpers (2) liegt.

11. Leistungshalbleiterbauelement nach Anspruch 10, wobei
das zweite Teilprofil (540) eine vierte Eindringtiefe (542) aufweist und diese vierte Eindringtiefe (542) des zweiten Teilprofils (540) des zweiten zweistufigen Dotierungsprofils (500) zwischen 40% und 70% vorzugsweise zwischen 50% und 60% der dritten Eindringtiefe (522) des ersten Teilprofils (520) beträgt.

12. Leistungshalbleiterbauelement nach Anspruch 11, wobei
die vierte Eindringtiefe (542) des zweiten Teilprofils (540) des zweiten zweistufigen Dotierungsprofils (500) mindestens 20%, vorzugsweise mindestens 30%, der lateralen Ausdehnung des Grundkörpers (2) beträgt.

13. Leistungshalbleiterbauelement nach Anspruch 10, wobei
die Konzentration von Dotierstoffatomen an der zweiten Hauptfläche (8) mit erster Leitfähigkeit erzeugt durch das erste Teilprofil (520) um mindesten 2 Größenordnungen geringer ist als dasjenige erzeugt durch das zweite Teilprofil (540).

14. Leistungshalbleiterbauelement nach Anspruch 13, wobei
die Konzentration von Dotierstoffatomen an der zweiten Hauptfläche (8) zwischen 10¹⁸ und 10²¹ cm⁻² beträgt

## Claims

1. Power semiconductor component (1) having at least one functional pn junction (4), having a basic body (2) with a first basic conductivity,
a well-like region (10) with a second conductivity which is arranged horizontally centrally in the basic body (2), has a first two-level doping profile (100) and has a first penetration depth (102) from the first main surface (6) into the basic body (2), wherein the level (130) of the first two-level doping profile (100) of the well-like region (10) is designed to be in the range between 10% and 40% of the first penetration depth (102), wherein the first two-level doping profile (100) is formed by two profile elements with the first penetration depth (122) of 3µm to 4µm and a second profile element with a second penetration depth (142) suitable for producing said first two-level doping profile (100),
having an edge structure which is arranged between the well-like region (10) and the edge of the power semiconductor component (1) and which comprises a plurality of field rings (20) with a single-level doping profile, a second conductivity and a second penetration depth (202), arranged in the basic body (2), a field plate structure (40) which is associated with these field rings (20) and a passivation (30) for this edge structure, wherein
the first penetration depth (102) is no more than 50 of 100 of the second penetration depth (202),
each field ring (20) has an associated conductive moulding (40) as a field plate having a first body element (42) arranged horizontally centrally on the field ring (40), wherein these first body elements (42) have a first passivation layer (32) arranged between them, and having at least one second body element (44) which is laterally spaced from the basic body (2) and projects horizontally above the associated field ring (20) in the direction of the edge of the power semiconductor component (1).

2. Power semiconductor component according to Claim 1, wherein
a second body element (44) projects above the associated field ring (20) horizontally in the direction of the centre of the power semiconductor component (1).

3. Power semiconductor component according to Claim 1, wherein
the concentration of second dopant atoms on the first main surface (6) of the well-like region (10) is between 10¹⁷ and 10²⁰ cm⁻².

4. Power semiconductor component according to Claim 1, wherein
the surface of the well-like region (10) of second conductivity has a metal contact layer (18) arranged on it.

5. Power semiconductor component according to Claim 1, wherein
the first passivation layer (32) has a second passivation layer (34) arranged above it.

6. Power semiconductor component according to Claim 5, wherein
the first passivation layer (32) is silicon oxide and the second passivation layer (34) is a polyimide.

7. Power semiconductor component according to Claim 6, wherein
the first passivation layer (32) and the second passivation layer (34) have a layer of silicon nitrite arranged between them.

8. Power semiconductor component according to Claim 5, wherein
the second passivation layer (34) completely covers the conductive mouldings (40).

9. Power semiconductor component according to Claim 1, wherein
the conductive moulding (40) and the body elements (42, 44) thereof comprise metal or doped polysilicon.

10. Power semiconductor component according to Claim 1, wherein
from the second main surface (8) a second two-level doping profile (500) of first conductivity having a third penetration depth (502) is produced which extends into the interior of the basic body (2), wherein said third penetration depth (502) of the first doping of the second doping profile (500) is in the region of half the lateral extent of the basic body (2).

11. Power semiconductor component according to Claim 10, wherein
the second profile element (540) has a fourth penetration depth (542), and this fourth penetration depth (542) of the second profile element (540) of the second two-level doping profile (500) is between 40% and 70%, preferably between 50% and 60%, of the third penetration depth (522) of the first profile element (520) .

12. Power semiconductor component according to Claim 11, wherein
the fourth penetration depth (542) of the second profile element (540) of the second two-level doping profile (500) is at least 20%, preferably at least 30%, of the lateral extent of the basic body (2).

13. Power semiconductor component according to Claim 10, wherein
the concentration of dopant atoms on the second main surface (8) with a first conductivity produced by the first profile element (520) is at least 2 orders of magnitude lower than that produced by the second profile element (540).

14. Power semiconductor component according to Claim 13, wherein
the concentration of dopant atoms on the second main surface (8) is between 10¹⁸ and 10²¹ cm⁻².

## Revendications

1. Composant semi-conducteur de puissance (1) comprenant au moins une jonction p-n fonctionnelle (4), un corps de base (2) de première conductivité de base, une région (10) en forme de cuvette, de deuxième conductivité, qui est disposée horizontalement au milieu dans le corps de base (2) et qui présente un premier profil de dopage à deux étages (100) et une première profondeur de pénétration (102) allant de la première surface principale (6) jusque dans le corps de base (2), l'étage (130) du premier profil de dopage à deux étages (100) de la région (10) en forme de cuvette étant formé dans la région allant de 10 % à 40 % de la première profondeur de pénétration (102), le premier profil de dopage à deux étages (100) étant formé de deux parties de profil qui présentent la première profondeur de pénétration (122) allant de 3 µm à 4 µm et qui comportent une deuxième partie de profil qui présente une deuxième profondeur de pénétration (142) appropriée pour former ledit premier profil de dopage à deux étages (100), une structure de bord qui est disposée entre la région (10) en forme de cuvette et le bord du composant semi-conducteur de puissance (1) et qui est formée d'une pluralité d'anneaux de champ (20), qui présentent un profil de dopage à un étage, une deuxième conductivité et une deuxième profondeur de pénétration (202) et qui sont disposés dans le corps de base (2), d'une structure de plaque de champ (40) associée à ces anneaux de champ (20) et un moyen (30) de passivation de cette structure de bord, la première profondeur de pénétration (102) étant au maximum de 50 % à 100 % de la deuxième profondeur de pénétration (202), chaque anneau de champ (20) étant associé à un corps moulé conducteur (40) se présentant sous la forme d'une plaque de champ pourvue d'une première partie de corps (42) disposée horizontalement au milieu de l'anneau de champ (40), une première couche de passivation (32) étant disposée entre ces premières parties de corps (42), et d'au moins une deuxième partie de corps (44) qui est espacée latéralement du corps de base (2) et qui fait saillie horizontalement de l'anneau de champ associé (20) en direction du bord du composant semi-conducteur de puissance (1).

2. Composant semi-conducteur de puissance selon la revendication 1,
une deuxième partie de corps (44) faisant saillie de l'anneau de champ associé (20) horizontalement en direction du milieu du composant semi-conducteur de puissance (1).

3. Composant semi-conducteur de puissance selon la revendication 1,
la concentration en deuxièmes atomes dopants sur la première surface principale (6) de la région (10) en forme de cuvette étant comprise entre 10¹⁷ et 10²⁰ cm⁻².

4. Composant semi-conducteur de puissance selon la revendication 1,
une couche de contact métallique (18) étant disposée sur la surface de la région (10) en forme de cuvette de deuxième conductivité.

5. Composant semi-conducteur de puissance selon la revendication 1, une deuxième couche de passivation (34) étant disposée au-dessus de la première couche de passivation (32).

6. Composant semi-conducteur de puissance selon la revendication 5,
la première couche de passivation (32) étant un oxyde de silicium et la deuxième couche de passivation (34) étant un polyimide.

7. Composant semi-conducteur de puissance selon la revendication 6,
une couche de nitrure de silicium étant disposée entre la première couche de passivation (32) et la deuxième couche de passivation (34).

8. Composant semi-conducteur de puissance selon la revendication 5,
la deuxième couche de passivation (34) recouvrant complètement les corps moulés conducteurs (40).

9. Composant semi-conducteur de puissance selon la revendication 1,
le corps moulé conducteur (40) et ses parties de corps (42, 44) sont en métal ou en polysilicium dopé.

10. Composant semi-conducteur de puissance selon la revendication 1,
un deuxième profil de dopage à deux étages (500) de première conductivité, qui s'étend de la deuxième surface principale (8) jusqu'à l'intérieur du corps principal (2), est formé avec une troisième profondeur de pénétration (502), cette troisième profondeur de pénétration (502) du premier dopage du deuxième profil de dopage (500) étant située dans la région de la moitié de l'extension latérale du corps de base (2).

11. Composant semi-conducteur de puissance selon la revendication 10,
la deuxième partie de profil (540) présentant une quatrième profondeur de pénétration (542) et cette quatrième profondeur de pénétration (542) de la deuxième partie de profil (540) du deuxième profil de dopage à deux étages (500) étant comprise entre 40 % et 70 %, de préférence entre 50 % et 60 % de la troisième profondeur de pénétration (522) de la première partie de profil (520) .

12. Composant semi-conducteur de puissance selon la revendication 11,
la quatrième profondeur de pénétration (542) de la deuxième partie de profil (540) du deuxième profil de dopage à deux étages (500) représentant au moins 20 %, de préférence au moins 30 %, de l'extension latérale du corps de base (2).

13. Composant semi-conducteur de puissance selon la revendication 10,
la concentration en atomes dopants sur la deuxième surface principale (8) de première conductivité générée par la première partie de profil (520) étant inférieure d'au moins 2 ordres de grandeur à celle générée par la deuxième partie de profil (540).

14. Composant semi-conducteur de puissance selon la revendication 13,
la concentration en atomes dopants sur la deuxième surface principale (8) étant comprise entre 10¹⁸ et 10²¹ cm⁻².
